(19) **Europäisches Patentamt / European Patent Office / Office européen des brevets**

(11) **EP 2 609 635 B1**

(12) **EUROPEAN PATENT SPECIFICATION**

(45) Date of publication and mention
of the grant of the patent:
**22.02.2017 Bulletin 2017/08**

(21) Application number: **11820106.0**

(22) Date of filing: **30.06.2011**

(51) Int Cl.:
*H01L 35/12* (2006.01)     *H01L 35/32* (2006.01)
*H01L 35/18* (2006.01)     *H01L 35/16* (2006.01)

(86) International application number:
**PCT/KR2011/004793**

(87) International publication number:
**WO 2012/026678 (01.03.2012 Gazette 2012/09)**

(54) **THERMOELECTRIC MODULE COMPRISING THERMOELECTRIC ELEMENT DOPED WITH NANOPARTICLES AND MANUFACTURING METHOD OF THE SAME**

THERMOELEKTRISCHES MODUL MIT EINEM MIT NANOPARTIKELN DOTIERTEN THERMOELEKTRISCHEN ELEMENT UND HERSTELLUNGSVERFAHREN DAFÜR

MODULE THERMOÉLECTRIQUE COMPRENANT UN ÉLÉMENT THERMOÉLECTRIQUE DOPÉ PAR DES NANOPARTICULES ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.08.2010 KR 20100082765**

(43) Date of publication of application:
**03.07.2013 Bulletin 2013/27**

(73) Proprietor: **LG Innotek Co., Ltd.**
**Seoul 100-714 (KR)**

(72) Inventor: **SHIN, Jong Bae**
**Seoul 100-714 (KR)**

(74) Representative: **Novagraaf Technologies**
**Bâtiment O2**
**2, rue Sarah Bernhardt**
**CS90017**
**92665 Asnières-sur-Seine Cedex (FR)**

(56) References cited:
**WO-A1-03/032408      WO-A1-2009/026466**
**KR-A- 20090 021 270      KR-A- 20090 110 831**
**US-A1- 2001 052 234      US-A1- 2006 118 158**
**US-A1- 2006 272 697**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical Field**

This application claims priority to Korean Patent Application No. 10-2010-0082765 filed on August 26, 2010.
The present invention relates to a structure of thermoelectric module for heat transfer and a method of manufacturing the same.

**Background Art**

A thermoelectric phenomenon is a phenomenon in which heat emission and cooling occurs (Peltier effect) at both ends of a material bonding portion by applying a current between two materials or in which an electromotive force occurs (seebeck effect) by a temperature difference between two materials, and a thermoelectric element is a metal or a ceramic element having a function of directly converting a heat to electricity or electricity to a heat. By using such a seebeck effect, a heat generating in a computer or a vehicle engine can be converted to electrical energy, and by using a Peltier effect, various cooling systems that do not require a refrigerant can be embodied. Interest has increased in new energy development, waste energy recovery, and environment protection and thus interest in a thermoelectric element has also increased.
In the 1950s, since a Bi-Te-based thermoelectric element was developed, a thermoelectric performance index representing energy conversion efficiency of a thermoelectric material has shown a value of 1 or less at a normal temperature, and maximum cooling efficiency that can obtain through the thermoelectric performance index is about 8% and thus it was limited to use the thermoelectric element for various electronic devices, but in the 2000s, as a nano material and process technology such as a super lattice structure or a quantum confinement effect are added to the thermoelectric element, a thermoelectric performance index remarkably improves and until now, a thermoelectric element having a thermoelectric performance index of 2.4 as a highest value has been reported.
Further, by manufacturing a thermoelectric material in a nano structure having a length unit corresponding to a characteristic wavelength from a wavelength of phonon that charges heat transfer within a material and an average free path of electrons (or holes) that charge electricity transmission, an electron energy level density is controlled, the constant and conductivity of a relative large value are obtained, and a seebeck value of a thermoelectric performance index is improved, or by scattering phonon that charges heat transfer, thermal conductivity is suppressed, and by adjusting an energy band gap, a thermoelectric performance index is remarkably improved with a method of sustaining electrical conductivity.
Efficiency of the thermoelectric element can be generally evaluated with a thermoelectric index represented by the following Equation, and as a thermoelectric index increases, a generating potential difference increases and thus an excellent characteristic is represented.

$$[7] \qquad ZT = (S^2 \sigma/k)T$$

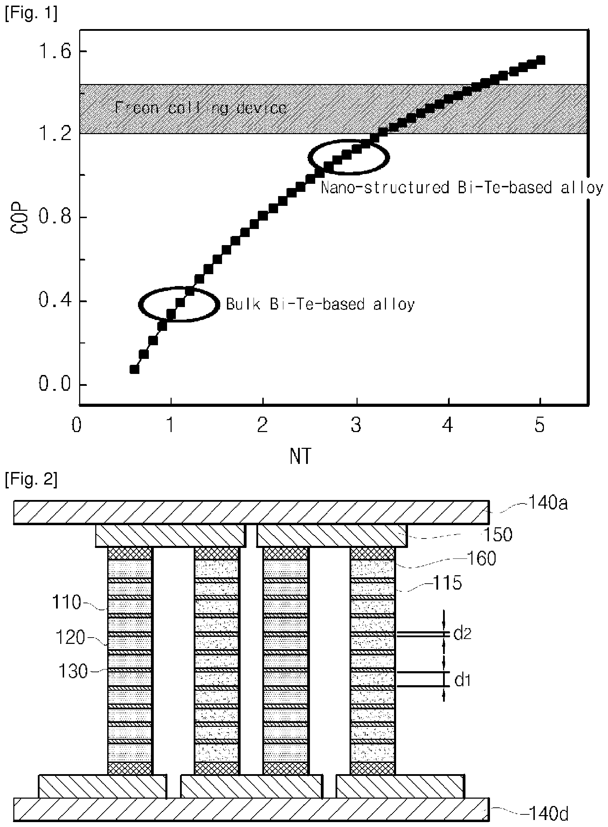

In the Equation, a ZT coefficient is proportional to a seebeck coefficient S and electrical conductivity $\sigma$ of a thermoelectric material and is inversely proportional to thermal conductivity k. Here, a seebeck coefficient represents a magnitude (dV/dT) of a voltage generated according to a unit temperature change. Therefore, in the Equation, in order to apply a ZT coefficient to a thermoelectric element, it is preferable that a thermoelectric material has a large seebeck coefficient and large electric conductivity and small thermal conductivity, but because a seebeck coefficient, electrical conductivity, and thermal conductivity are not independent variables, it is not easy to embody a thermoelectric element having a large ZT coefficient, i.e., excellent efficiency.
In a conventional thermoelectric element cooling method, a thermoelectric element is mainly manufactured in a bulk type, and it has been actively researched to manufacture a thermoelectric element in a nano type, as described above. The reason of changing a manufacturing method from a bulk type to a nano type is that the bulk type has a low thermoelectric index ZT and thus manufactures only a thermoelectric element having low efficiency, as shown in FIG. 1. When a nano element of high efficiency is manufactured, a production cost sharply increases.
WO03/032408 discloses a thermoelectric device.

**EP 2 609 635 B1**

## J Disclosure of Invention

### Technical Problem

The present invention has been made in view of the above problems, and provides a thermoelectric module and a method of manufacturing the same that have a thermoelectric index value larger than that of an existing bulk type thermoelectric element without a high manufacturing cost by doping a bulk type thermoelectric element with nano particles and recoupling them and thus by blocking a path of phonon.

### Solution to Problem

In accordance with an aspect of the present invention, a thermoelectric module including a thermoelectric element according to claim 1.

The plurality of thermoelectric elements may be disposed in a structure connected in series through an electrode pattern formed at the other surface of the first and second insulating substrates.

The phonon scattering film may be formed with one of antimony (Sb), selenium (Se), boron (B), gallium (Ga), and indium (In).

The nano particle may have a particle diameter of 1nm to 100nm. Particularly, in this case, the nano particle may be formed with one of antimony (Sb), selenium (Se), boron (B), gallium (Ga), and indium (In).

The thermoelectric module may include a diffusion preventing film formed between the metal electrode and the thermoelectric element.

The diffusion preventing film may be formed with at least one of Pb, Sn, Pt, and Ni.

The first and second substrates may be formed using one of a silicon substrate, aluminum, aluminum nitride (AlN), aluminum oxide (AlO$_x$), photo sensitive glass (PSG), BeO, a printed circuit board (PCB), and alumina (Al$_2$O$_3$).

A thermoelectric module according to the present invention can be manufactured through the following process.

In accordance with another aspect of the present invention, a method of manufacturing a thermoelectric module according to claim 11.

The doping of the plurality of n-type and p-type thermoelectric semiconductor elements with nano particles may include doping n-type and p-type thermoelectric semiconductor elements having a thickness of 0.01 mm to 0.1 mm with nano particles having a particle diameter of 1nm to 100nm.

The doping of the plurality of n-type and p-type thermoelectric semiconductor elements with nano particles may include doping with nano particles formed with one of antimony (Sb), selenium (Se), boron (B), gallium (Ga), and indium (In).

The forming of a phonon scattering film may include forming a phonon scattering film formed with one of antimony (Sb), selenium (Se), boron (B), gallium (Ga), and indium (In).

The method may further comprise forming a diffusion preventing film at both ends of the plurality of n-type and p-type thermoelectric semiconductor elements, after forming a plurality of n-type and p-type thermoelectric semiconductor elements doped with the nano particles.

### Advantageous Effects of Invention

According to the present invention, in order to prevent movement of phonon that charges movement of a heat in a plurality of bulk type thermoelectric semiconductors, by depositing a phonon scattering film for scattering phonon and recoupling them while doping with nano particles, a path of the phonon is blocked and thus a thermoelectric module including a thermoelectric element having a higher thermal index than that of an existing bulk type thermoelectric element can be embodied.

### Brief Description of Drawings

FIG. 1 is a graph of comparing a bulk type thermoelectric index and a nano type thermoelectric index;
FIG. 2 is a cross-sectional view illustrating a thermoelectric module including a thermoelectric element doped with nano particles according to an exemplary embodiment of the present invention; and
FIG. 3 is a diagram illustrating a process of manufacturing a thermoelectric module including a thermoelectric element doped with nano particles according to an exemplary embodiment of the present invention.

<Description of Reference Numerals Indicating Primary Elements in the Drawings>

110, 115: n-type thermoelectric semiconductor element, p-type thermoelectric semiconductor element

120: nano particle
130: phonon scattering film
140a, 140b: first substrate, second substrate
150: metal electrode
160: diffusion preventing film

## Best Mode for Carrying out the Invention

The present invention relates to a thermoelectric module including a thermoelectric element doped with nano particles and a method of manufacturing the same, and more particularly, to a thermoelectric module and a method of manufacturing the same that can have a higher thermoelectric index value by doping nano particles on several bulk type base members and recoupling them and thus by blocking a path of phonon.

In accordance with an aspect of the present invention, a thermoelectric module including a thermoelectric element doped with nano particles includes: first and second substrates including a metal electrode and disposed opposite to each other; and a plurality of thermoelectric elements disposed between the first and second substrates, wherein the thermoelectric elements are doped with nano particles.

In accordance with another aspect of the present invention, a method of manufacturing a thermoelectric module including a thermoelectric element doped with nano particles, the method includes: forming a plurality of n-type and p-type thermoelectric semiconductor elements doped with nano particles; and electrically connecting the plurality of n-type and p-type thermoelectric semiconductor elements by alternately arranging the plurality of n-type and p-type thermoelectric semiconductor elements between first and second substrates in which a metal electrode is formed.

## Mode for the Invention

Hereinafter, a configuration and function according to an exemplary embodiment of the present invention will be described in detail with reference to the attached drawings. When describing a detailed description with reference to the attached drawings, like reference numerals in the drawings denote like elements. Terms such as a first and a second are used for describing various elements, but the elements are not limited by the terms. The terms are used for distinguishing one element from other elements.

FIG. 2 is a cross-sectional view illustrating a thermoelectric module including a thermoelectric element doped with nano particles according to an exemplary embodiment of the present invention.

Referring to FIG. 2, a thermoelectric module including a thermoelectric element doped with nano particles according to an exemplary embodiment of the present invention includes a metal electrode 150 and a first substrate 140a and a second substrate 140b disposed opposite to each other, and a plurality of thermoelectric elements 110 and 115 are disposed between the first substrate and the second substrate.

The thermoelectric elements are doped with nano particles.

It is preferable that the first substrate 140a and the second substrate 140b are ceramic substrates and are formed with alumina ($Al_2O_3$), but are not limited thereto and can be formed using one of a silicon substrate, aluminum, aluminum nitride (AlN), aluminum oxide ($AlO_x$), photo sensitive glass (PSG), $Al_2O_3$, BeO, and a PCB.

The thermoelectric elements are disposed in a structure disposed in parallel between the first substrate 140a and the second substrate 140b, specifically, in a pillar structure in which at least one thermoelectric element supports the first substrate 140a and the second substrate 140b, and the thermoelectric elements are separately disposed at a predetermined gap, and at each thermoelectric element, n-type and p-type thermoelectric semiconductor elements 110 and 115 are alternately disposed. A plurality of nano particles 120 are doped within the n-type and p-type thermoelectric semiconductor elements 110 and 115.

Therefore, in each thermoelectric element, i.e., in thermoelectric elements doped with a plurality of nano particles 120, a plurality of n-type and p-type thermoelectric semiconductor elements 110 and 115 doped with nano particles are alternately and separately arranged, and the thermoelectric semiconductor elements 110 and 115 are electrically connected in series by the metal electrode 150 and are disposed in parallel.

In this case, it is preferable that the nano particles 120 have a particle diameter of 1nm to 100nm and are formed with one of antimony (Sb), selenium (Se), boron (B), gallium (Ga), and indium (In). In this way, because phonon that charges movement of heat can be prevented from moving through the nano particles 120, a thermoelectric index increases, and thus efficiency increases.

Further, the n-type and p-type thermoelectric semiconductor elements 110 and 115 doped with the nano particles 120 may include a phonon scattering film 130 formed at a predetermined gap in order to scatter phonon.

The phonon scattering film 130 has a thickness d2 of 1nm to 100nm and is formed with one of antimony (Sb), selenium (Se), boron (B), gallium (Ga), and indium (In).

Further, it is preferable that the phonon scattering film 130 is formed at a gap d1 of 0.01 mm to 0.1 mm. The phonon scattering film 130 is deposited at one end of a plurality of thermoelectric semiconductor elements 110 and and then by bonding a plurality of thermoelectric semiconductor elements 110 and 115 in which the phonon scattering film 130 is formed, a thermoelectric semiconductor element arranged in a thermoelectric module is formed, and this will be described in detail in the following manufacturing process.

Further, a diffusion preventing film 160 for preventing a metal from being diffused may be formed between the metal electrode 150 and the thermoelectric semiconductor element, and the diffusion preventing film 160 is preferably formed with nickel (Ni). Alternatively, the diffusion preventing film may be formed with at least one of Pb, Sn, Pt, and Ni.

Table 1 illustrates thermoelectric indexes ZT and production costs of an existing bulk type thermoelectric element, a thermoelectric element doped with only nano particles, a thermoelectric element doped with nano particles and in which a phonon scattering film is formed, and a super lattice thermoelectric element.

[Table 1]

| | Bulk type thermoelectric element | Thermoelectric element doped with nano particles | Thermoelectric element doped with nano particles and in which phonon scattering film is formed | Super lattice thermoelectric element |
|---|---|---|---|---|
| ZT | 1.0 | 1.5 | 1.75 | 2.5 |
| Cost (USD) | 5-200 | 100-1,000 | 100-500 | 5,000 |

As can be seen in Table 1, when a thermoelectric performance index of an existing bulk type thermoelectric element is 1.0, a thermoelectric element doped with the nano particles 120 has a performance further improved by 50% than a thermoelectric element in which only an existing bulk material is used, and a thermoelectric element doped with nano particles and in which a phonon scattering film 130 is formed has a performance further improved by 75% than a thermoelectric element in which only an existing bulk material is used. When forming nano particles, a bulk has a thin thickness, compared with an existing method, and thus particles can be relatively easily formed, and a super lattice thermoelectric element that cannot be formed in a large area and that requires a high production cost cannot be used, and an effect for preventing phonon from moving can be maximized.

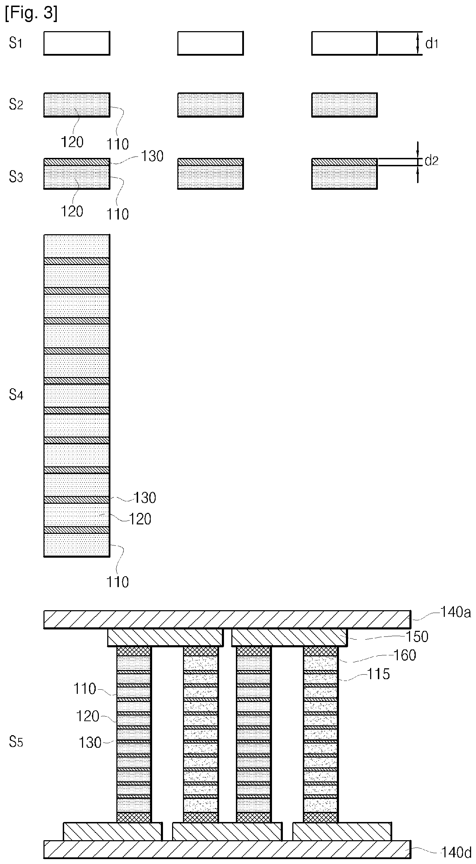

FIG. 3 is a diagram illustrating a process of manufacturing a thermoelectric module including a thermoelectric element doped with nano particles according to an exemplary embodiment of the present invention.

Referring to FIG. 3, a plurality of n-type and p-type thermoelectric semiconductor elements 110 having a thickness d1 0.01mm to 0.1mm smaller than a thickness 1mm to 2mm of an existing bulk type thermoelectric semiconductor element are manufactured (S1), and the thermoelectric semiconductor element is made of a bismuth telluride (BiTe)-based material. Thereafter, in order to prevent movement of phonon that charges movement of a heat, the nano particles 120 are formed in the plurality of thermoelectric semiconductor elements 110 (S2). In this case, it is preferable that the nano particle 120 has a particle diameter of 1 to 100nm and is made of one of antimony (Sb), selenium (Se), boron (B), gallium (Ga), and indium (In).

Next, at one end of the thermoelectric semiconductor element 110 doped with the nano particles 120, the phonon scattering film 130 for scattering phonon is coated or deposited (S3), and the phonon scattering film 130 has a thickness of 1nm to 100nm and is made of one of antimony (Sb), selenium (Se), boron (B), gallium (Ga), and indium (In), similarly to the nano particle 120.

By bonding in a line the thermoelectric semiconductor elements 110 in which the phonon scattering film 130 is formed, a thermoelectric semiconductor element to be arranged in a thermoelectric module is formed (S4), and the n-type and p-type thermoelectric semiconductor elements are alternately arranged between the first substrate 140a and the second substrate 140b such as alumina in which the metal electrode 150 is formed, but the n-type and p-type thermoelectric semiconductor elements are electrically connected in series through the metal electrode 150 (S5). In this case, in order to prevent a metal from being diffused before connecting the thermoelectric semiconductor elements 110 and 115 and the metal electrode 150, it is preferable to form the diffusion preventing film 160 at both ends of the thermoelectric semiconductor element, and in this case, the diffusion preventing film 160 is preferably formed with nickel (Ni). In this way, by preventing phonon from moving through the nano particles 120 and the phonon scattering film 130, a thermoelectric index increases without a high production cost and thus a thermoelectric module having excellent efficiency can be manufactured.

**Claims**

1. A thermoelectric module comprising a thermoelectric element doped with nano particles, the thermoelectric module comprising:

   first and second substrates comprising a metal electrode and disposed opposite to each other; and
   a plurality of thermoelectric elements disposed between the first and second substrates,

   wherein the thermoelectric elements are doped with nano particles,
   wherein the plurality of thermoelectric elements are formed in a structure in which n-type thermoelectric semiconductor elements and p-type thermoelectric semiconductor elements doped with nano particles are alternately disposed,
   said n-type and p-type thermoelectric semiconductor elements doped with nano particles comprising a phonon scattering film formed at a predetermined gap. **characterized in that** the phonon scattering film has a thickness of 1 to 100 nm.

2. The thermoelectric module of claim 1, wherein the plurality of thermoelectric elements are disposed in a structure connected in series through an electrode pattern formed at the other surface of the first and second substrates.

3. The thermoelectric module of claim 2, wherein the phonon scattering film and the nano particles are composed of the same material.

4. The thermoelectric module of claim 2, wherein the phonon scattering film is formed at a gap of 0.01 mm to 0.1 mm.

5. The thermoelectric module of anyone of claims 2 to 4, wherein the phonon scattering film is formed with one of antimony (Sb), selenium (Se), boron (B), gallium (Ga), and indium (In).

6. The thermoelectric module of claim 2 or 3, wherein the nano particle has a particle diameter of 1 nm to 100nm

7. The thermoelectric module of claim 6, wherein the nano particle is formed with one of antimony (Sb), selenium (Se), boron (B), gallium (Ga), and indium (In).

8. The thermoelectric module of claim 3 or 4 claim 2 or 3, wherein the thermoelectric module comprises a diffusion preventing film formed between the metal electrode and the thermoelectric element.

9. The thermoelectric module of claim 8, wherein the diffusion preventing film is formed with at least one of Pb, Sn, Pt, and Ni.

10. The thermoelectric module of anyone of claims 1 to 9, wherein the first and second substrates are formed using one of a silicon substrate, aluminum, aluminum nitride (AlN), aluminum oxide (AlOx), photo sensitive glass (PSG), BeO, a printed circuit board (PCB), and alumina (Al2O3).

11. A method of manufacturing a thermoelectric module comprising a thermoelectric element doped with nano particles, the method comprising:

    doping a plurality of n-type and p-type thermoelectric semiconductor elements with nano particles;
    forming a phonon scattering film having a thickness 1 to 100 nm at one end of the plurality of n-type and p-type semiconductor elements doped with the nano particles;
    forming a plurality of bonded n-type and p-type thermoelectric semiconductor elements by bonding each of n-type and p-type thermoelectric semiconductor elements in which the phonon scattering film is formed; and
    electrically connecting the plurality of n-type and p-type thermoelectric semiconductor elements by alternately arranging the plurality of n-type and p-type thermoelectric semiconductor elements between first and second substrates in which a metal electrode is formed.

12. The method of claim 11, wherein the doping of the plurality of n-type and p-type thermoelectric semiconductor elements with the nano particles comprises doping n-type and p-type thermoelectric semiconductor elements having a thickness of 0.01 to 0.1mm with nano particles having a particle diameter of 1 to 100nm.

**13.** The method of anyone of claims 11 and 12, wherein the doping of the plurality of n-type and p-type thermoelectric semiconductor elements with the nano particles comprises doping with nano particles formed with one of antimony (Sb), selenium (Se), boron (B), gallium (Ga), and indium (In).

**14.** The method of anyone of claims 11 to 13, wherein the forming of a phonon scattering film comprises forming a phonon scattering film formed with one of antimony (Sb), selenium (Se), boron (B), gallium (Ga), and indium (In).

**15.** The method of claim 14, wherein the phonon scattering film and the nano particles are composed of the same material.

**16.** The method of claim 11, after forming a plurality of n-type and p-type thermoelectric semiconductor elements doped with the nano particles and then further comprising forming a diffusion preventing film at both ends of the plurality of n-type and p-type thermoelectric semiconductor elements.

**Patentansprüche**

**1.** Thermoelektrisches Modul, umfassend ein thermoelektrisches Element, das mit Nanoteilchen dotiert ist, wobei das thermoelektrische Modul Folgendes umfasst:

erste und zweite Substrate, die eine Metallelektrode umfassen und einander gegenüber angeordnet sind; und eine Mehrzahl von thermoelektrischen Elementen, die zwischen dem ersten und dem zweiten Substrat angeordnet ist,

wobei die thermoelektrischen Elemente mit Nanoteilchen dotiert sind, wobei die Mehrzahl von thermoelektrischen Elementen in einer Struktur gebildet ist, in der n-Typthermoelektrische Halbleiterelemente und p-Typ-thermoelektrische Halbleiterelemente, die mit Nanoteilchen dotiert sind, abwechselnd angeordnet sind, wobei die n-Typ- und p-Typ-thermoelektrischen Halbleiterelemente, die mit Nanoteilchen dotiert sind, eine Phononenstreuschicht umfassen, die an einem vorbestimmten Spalt gebildet ist, **dadurch gekennzeichnet, dass**:

die Phononenstreuschicht eine Dicke von 1 bis 100 nm aufweist.

**2.** Thermoelektrisches Modul nach Anspruch 1, wobei die Mehrzahl von thermoelektrischen Elementen in einer Struktur angeordnet ist, die in Serie durch ein Elektrodenmuster verbunden ist, das an der anderen Oberfläche der ersten und zweiten Substrate gebildet ist.

**3.** Thermoelektrisches Modul nach Anspruch 2, wobei die Phononenstreuschicht und die Nanoteilchen aus dem gleichen Material zusammengesetzt sind.

**4.** Thermoelektrisches Modul nach Anspruch 2, wobei die Phononenstreuschicht an einem Spalt von 0,01 mm bis 0,1 mm gebildet ist.

**5.** Thermoelektrisches Modul nach einem der Ansprüche 2 bis 4, wobei die Phononenstreuschicht mit einem von Antimon (Sb), Selen (Se), Bor (B), Gallium (Ga) und Indium (In) gebildet ist.

**6.** Thermoelektrisches Modul nach Anspruch 2 oder 3, wobei das Nanoteilchen einen Teilchendurchmesser von 1 nm bis 100 nm aufweist.

**7.** Thermoelektrisches Modul nach Anspruch 6, wobei das Nanoteilchen mit einem von Antimon (Sb), Selen (Se), Bor (B), Gallium (Ga) und Indium (In) gebildet ist.

**8.** Thermoelektrisches Modul nach Anspruch 3 oder 4 oder nach Anspruch 2 oder 3, wobei das thermoelektrische Modul eine Diffusionsverhinderungsschicht umfasst, die zwischen der Metallelektrode und dem thermoelektrischen Element gebildet ist.

**9.** Thermoelektrisches Modul nach Anspruch 8, wobei die Diffusionsverhinderungsschicht mit mindestens einem von Pb, Sn, Pt, und Ni gebildet ist.

**10.** Thermoelektrisches Modul nach einem der Ansprüche 1 bis 9, wobei das erste und das zweite Substrat mithilfe eines von Siliciumsubstrat, Aluminium, Aluminiumnitrid (AIN), Aluminiumoxid (AlOx), photoempfindlichem Glas (PSG), BeO, einer Leiterplatte (PCB) und Aluminiumoxid (Al$_2$O$_3$) gebildet sind.

**11.** Verfahren zum Herstellen eines thermoelektrischen Moduls, umfassend ein thermoelektrisches Element, das mit Nanoteilchen dotiert ist, wobei das Verfahren Folgendes umfasst:

Dotieren einer Mehrzahl von n-Typ- und p-Typ-thermoelektrischen Halbleiterelementen mit Nanoteilchen;
Bilden einer Phononenstreuschicht mit einer Dicke von 1 bis 100 nm an einem Ende der Mehrzahl von n-Typ- und p-Typ-Halbleiterelementen, die mit Nanoteilchen dotiert ist;
Bilden einer Mehrzahl von gebundenen n-Typ- und p-Typ-thermoelektrischen Halbleiterelementen durch Binden jedes der n-Typ- und p-Typ-thermoelektrischen Halbleiterelemente, in denen die Phononenstreuschicht gebildet ist; und
elektrisches Verbinden der Mehrzahl von n-Typ- und p-Typ-thermoelektrischen Halbleiterelementen durch abwechselndes Anordnen der Mehrzahl von n-Typ- und p-Typ-thermoelektrischen Halbleiterelementen zwischen ersten und zweiten Substraten, in denen eine Metallelektrode gebildet ist.

**12.** Verfahren nach Anspruch 11, wobei das Dotieren der Mehrzahl n-Typ und p-Typ-thermoelektrischen Halbleiterelementen mit Nanoteilchen das Dotieren von n-Typ- und p-Typ-thermoelektrischen Halbleiterelementen mit einer Dicke von 0,01 bis 0,1 mm mit Nanoteilchen mit einem Teilchendurchmesser von 1 bis 100 nm umfasst.

**13.** Verfahren nach einem der Ansprüche 11 und 12, wobei das Dotieren der Mehrzahl von n-Typ- und p-Typ-thermoelektrischen Halbleiterelementen mit den Nanoteilchen das Dotieren mit Nanoteilchen umfasst, die mit einem von Antimon (Sb), Selen (Se), Bor (B), Gallium (Ga) und Indium (In) gebildet sind.

**14.** Verfahren nach einem der Ansprüche 11 bis 13, wobei das Bilden einer Phononenstreuschicht das Bilden einer Phononenstreuschicht umfasst, die mit einem von Antimon (Sb), Selen (Se), Bor (B), Gallium (Ga) und Indium (In) gebildet ist.

**15.** Verfahren nach Anspruch 14, wobei die Phononenstreuschicht und die Nanoteilchen aus dem gleichen Material zusammengesetzt sind.

**16.** Verfahren nach Anspruch 11 nach Bilden einer Mehrzahl von n-Typ- und p-Typ-thermoelektrischen Halbleiterelementen, die mit den Nanoteilchen dotiert sind, und danach ferner umfassend das Bilden einer Diffusionsverhinderungsschicht an beiden Enden der Mehrzahl von n-Typ- und p-Typ-thermoelektrischen Halbleiterelementen.


## Revendications

**1.** Module thermoélectrique comprenant un élément thermoélectrique dopé avec des nanoparticules, le module thermoélectrique comprenant :

un premier et un second substrat comprenant une électrode métallique et disposés l'un en face de l'autre ; et
une pluralité d'éléments thermoélectriques disposée entre le premier et le second substrat,

dans lequel les éléments thermoélectriques sont dopés avec des nanoparticules,
dans lequel la pluralité d'éléments thermoélectriques est formée dans une structure dans laquelle des éléments semi-conducteurs thermoélectriques de type n et des éléments semi-conducteurs thermoélectriques de type p dopés avec des nanoparticules sont disposés en alternance,
lesdits éléments semi-conducteurs thermoélectriques de type n et de type p dopés avec des nanoparticules comprenant un film de diffusion de phonons formé à un écartement prédéterminé,
**caractérisé en ce que** :

le film de diffusion de phonons possède une épaisseur de 1 à 100 nm.

**2.** Module thermoélectrique selon la revendication 1, dans lequel la pluralité d'éléments thermoélectriques est disposée dans une structure connectée en série par l'intermédiaire d'un motif d'électrode formé sur l'autre surface du premier et du second substrat.

**3.** Module thermoélectrique selon la revendication 2, dans lequel le film de diffusion de phonons et les nanoparticules sont composés du même matériau.

**4.** Module thermoélectrique selon la revendication 2, dans lequel le film de diffusion de phonons est formé à un écartement de 0,01 mm à 0,1 mm.

**5.** Module thermoélectrique selon l'une quelconque des revendications 2 à 4, dans lequel le film de diffusion de phonons est formé avec l'un parmi l'antimoine (Sb), le sélénium (Se), le bore (B), le gallium (Ga) et l'indium (In).

**6.** Module thermoélectrique selon la revendication 2 ou 3, dans lequel la nanoparticule possède un diamètre de particule de 1 nm à 100 nm.

**7.** Module thermoélectrique selon la revendication 6, dans lequel dans lequel la nanoparticule est formée avec l'un parmi l'antimoine (Sb), le sélénium (Se), le bore (B), le gallium (Ga) et l'indium (In).

**8.** Module thermoélectrique selon la revendication 3 ou 4 ou la revendication 2 ou 3, dans lequel le module thermoélectrique comprend un film empêchant la diffusion formé entre l'électrode métallique et l'élément thermoélectrique.

**9.** Module thermoélectrique selon la revendication 8, dans lequel le film empêchant la diffusion est formé avec au moins un parmi Pb, Sn, Pt et Ni.

**10.** Module thermoélectrique selon l'une quelconque des revendications 1 à 9, dans lequel le premier et le second substrat sont formés en utilisant un parmi un substrat de silicium, d'aluminium, de nitrure d'aluminium (AlN), d'un oxyde d'aluminium (AlOx), d'un verre photosensible (PSG), du BeO, d'une carte de circuit imprimé (PCB), et d'alumine ($Al_2O_3$).

**11.** Procédé de fabrication d'un module thermoélectrique comprenant un élément thermoélectrique dopé avec des nanoparticules, le procédé comprenant :

le dopage d'une pluralité d'éléments semi-conducteurs thermoélectriques de type n et de type p avec des nanoparticules ;
la formation d'un film de diffusion de phonons possédant une épaisseur de 1 à 100 nm à une extrémité de la pluralité d'éléments semi-conducteurs de type n et de type p dopés avec les nanoparticules ;
la formation d'une pluralité d'éléments semi-conducteurs thermoélectriques de type n et de type p liés par la liaison de chacun des éléments semi-conducteurs thermoélectriques de type n et de type p dans lesquels le film de diffusion de phonons est formé ; et
la connexion électrique de la pluralité d'éléments semi-conducteurs thermoélectriques de type n et de type p par l'agencement en alternance de la pluralité d'éléments semi-conducteurs thermoélectriques de type n et de type p entre le premier et le second substrat dans lesquels une électrode métallique est formée.

**12.** Procédé selon la revendication 11, dans lequel le dopage de la pluralité d'éléments semi-conducteurs thermoélectriques de type n et de type p avec les nanoparticules comprend le dopage d'éléments semi-conducteurs thermoélectriques de type n et de type p possédant une épaisseur de 0,01 à 0,1 mm avec des nanoparticules possédant un diamètre de particule de 1 à 100 nm.

**13.** Procédé selon l'une quelconque des revendications 11 et 12, dans lequel le dopage de la pluralité d'éléments semi-conducteurs thermoélectriques de type n et de type p avec les nanoparticules comprend un dopage avec des nanoparticules formées avec l'un parmi l'antimoine (Sb), le sélénium (Se), le bore (B), le gallium (Ga) et l'indium (In).

**14.** Procédé selon l'une quelconque des revendications 11 à 13, dans lequel la formation d'un film de diffusion de phonons comprend la formation d'un film de diffusion de phonons formé avec l'un parmi l'antimoine (Sb), le sélénium (Se), le bore (B), le gallium (Ga) et l'indium (In).

**15.** Procédé selon la revendication 14, dans lequel le film de diffusion de phonons et les nanoparticules sont composés du même matériau.

**16.** Procédé selon la revendication 11, après la formation d'une pluralité d'éléments semi-conducteurs thermoélectriques de type n et de type p dopés avec les nanoparticules et ensuite comprenant en outre la formation d'un film empêchant la diffusion aux deux extrémités de la pluralité d'éléments semi-conducteurs thermoélectriques de type n et de type p.

[Fig. 1]

[Fig. 2]

EP 2 609 635 B1

[Fig. 3]

S1

d1

S2

120    110    130

S3

d2

120    110

S4

130
120

110

140a
150
160
115

110
120
130

S5

140d

12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020100082765

- WO 03032408 A